# EUROPEAN PATENT APPLICATION

(11) **EP 4 615 185 A1**
(43) Date of publication of application: **10.09.2025**
(21) Application number: 23903094.3
(22) Date of filing: 13.10.2023
(51) Int. Cl.: H05K 9/00, C01B 32/956

(54) **RADIO WAVE ABSORBING SHEET**

(30) Priority: 12.12.2022 JP 2022198190
(71) Applicant: Kabushiki Kaisha Riken, Tokyo 102-8202 (JP)
(72) Inventor: KURAMAE Masaki, Kumagaya-shi, Saitama 360-8522 (JP); HIROSE Keita, Kumagaya-shi, Saitama 360-8522 (JP); EGUCHI Syuto, Kumagaya-shi, Saitama 360-8522 (JP); NIGORINUMA Taisei, Kumagaya-shi, Saitama 360-8522 (JP)
(74) Representative: Scott, Stephen John
(86) International application number: PCT/JP2023/037286
(87) International publication number: WO 2024/127795

(57) **Abstract**

An electromagnetic wave absorbing sheet that uses silicon carbide powder to impart light weight and high insulation properties and that can obtain an excellent noise attenuation effect in the submillimeter to millimeter wave bands is provided. The electromagnetic wave absorbing sheet of the present disclosure includes a substrate made of organic matter and a powder that is supported in the substrate and has silicon carbide (SiC) as a principal constituent. In X-ray diffraction using Cu-Kα as a radiation source on a surface of the electromagnetic wave absorbing sheet, a value I_{4H}/I_{6H} obtained by dividing a peak intensity I_{4H} derived from 4H-SiC appearing at 20 = 34.4° to 35° by a peak intensity I_{6H} derived from 6H-SiC appearing at 20 = 35° to 36° is a predetermined value or more.

## Description

### TECHNICAL FIELD

The present disclosure relates to an electromagnetic wave absorbing sheet.

### BACKGROUND

As communications become more advanced, devices that utilize electromagnetic waves in the 3 GHz to 80 GHz frequency range are becoming more widespread. For example, the 5^{th} generation communication system (5G), which began to be used as a commercial service in Japan in 2020, is increasingly making use of frequency bands around 3 GHz to 5 GHz, i.e., sub-6, and the millimeter wave band of 28 GHz to 40 GHz. In addition, submillimeter wave radars that use frequencies around 24 GHz and millimeter wave radars that use frequencies around 76 to 79 GHz are becoming more widespread in automobiles as autonomous driving systems become more sophisticated. However, problems with electromagnetic interference inside and outside such devices are becoming apparent. For this reason, electromagnetic wave absorbing sheets that function at frequencies where electromagnetic wave interference is a problem are being used.

An electromagnetic wave absorbing sheet functions by being mounted on a metal or other substrate having electrical conductivity, or by providing a conductive layer such as metal on the back surface of the electromagnetic wave absorbing sheet. With respect to a surface reflected wave reflected on the surface of the electromagnetic wave absorbing sheet, a secondary reflected wave that passes through the inside of the electromagnetic wave absorbing sheet, is totally reflected by the conductive material on the back surface, and is emitted from the surface of the electromagnetic wave absorbing sheet has a phase that is shifted by half a wavelength. The surface reflected wave and the secondary reflected wave cancel each other out, yielding electromagnetic wave absorption properties. The electromagnetic wave absorbing sheet has a structure in which a soft resin is used as the substrate and a filler for generating an electromagnetic wave absorption effect is supported thereon. The resonance peak of electromagnetic wave absorption is targeted at a specific frequency by controlling the material constants (permittivity, magnetic permeability) of the substrate included in the sheet and the thickness of the substrate. Since the material constants of the substrate can be adjusted by the substrate material, the amount of filler added, and the like, the added amount of filler is controlled within a required range. A typical example is one in which a flexible resin such as rubber or elastomer is used as the substrate, and carbonyl iron powder or spinel ferrite powder is added as a filler.

In recent years, electronic devices have become increasingly smaller. Electromagnetic wave absorbing sheets are therefore installed in a narrow space, and the electromagnetic wave absorbing sheet is required to have a thickness of 1 mm or less. In addition, demand has increased in recent years for lighter electronic devices, and the electromagnetic wave absorbing sheet is also preferably lighter. The specific gravity of the resin substrate does not change significantly according to the type of material, but the specific gravity of the loss material varies greatly according to the material. Therefore, although the added amount of filler is a factor, a carbon-based material or silicon carbide, which has a lighter specific gravity than carbonyl iron or soft ferrite, is preferably selected as the loss material from the perspective of weight reduction. In addition, in the case of an electromagnetic wave absorbing sheet compatible with devices that utilize electromagnetic waves of 3 GHz to 80 GHz, rather than using a magnetic filler, which does not easily achieve a high magnetic permeability in the microwave to millimeter wave band, as the loss material, the provision of electrical loss by having the resin substrate support a nonmagnetic conductive material increases the degree of freedom in designing the electromagnetic wave absorbing sheet. From the perspective of a practical, cost-effective nonmagnetic conductive filler as well, a carbon-based material or silicon carbide is preferably selected as the loss material.

Since the electromagnetic wave absorbing sheet is placed around an electronic circuit, if the electromagnetic wave absorbing sheet falls off from the mounting portion, there is a risk that the electromagnetic wave absorbing sheet will come into contact with the circuit and cause a short circuit if the surface resistivity of the electromagnetic wave absorbing sheet is less than 10¹⁰ Ω/sq. However, in the case of using a carbon-based loss material, an electromagnetic wave absorbing sheet to which the required amount for achieving an excellent electromagnetic wave absorption amount is added has a surface resistivity of less than 10¹⁰ Ω/sq. To address this, an insulation layer such as a PET film could be mounted on the surface of the sheet, but depending on the material of the insulation layer, this not only reduces the heat resistance and flame retardance but also leads to an increase in manufacturing costs. In addition, since the powder of carbon-based materials has a high cohesive force, it is generally difficult to disperse the carbon-based materials homogeneously in the substrate resin, which increases manufacturing variations. In electromagnetic wave absorbing sheets using a carbon-based loss material, special devices and processes are often required to reduce the dispersion variation of the loss material, but this is not desirable from the perspective of manufacturing costs.

On the other hand, in the case of using silicon carbide as a loss material, an electromagnetic wave absorbing sheet to which the required amount for achieving an excellent electromagnetic wave absorption amount is added has a surface resistivity exceeding 10¹⁰ Ω/sq. Furthermore, except for the case in which expensive silicon carbide fibers are used, silicon carbide is industrially used in the form of inexpensive particles, and is easily dispersed in a resin substrate. Therefore, to prepare an electromagnetic wave absorbing sheet that is lightweight and has high insulation properties, silicon carbide powder is preferably used as the loss material. An example of an electromagnetic wave absorbing sheet using silicon carbide powder as a loss material is described in Patent Literature (PTL) 1.

However, it was not known that the electromagnetic wave absorbing properties of an electromagnetic wave absorbing sheet obtained using silicon carbide powder as a loss material are greatly influenced by the crystal structure and impurity content of the silicon carbide powder. It is thought that the conductivity of silicon carbide powder affects the permittivity of the electromagnetic wave absorbing sheet, and that the desired electromagnetic wave absorbing sheet can be obtained by controlling the permittivity, that is, by controlling the crystal structure, impurity content, particle size, and added amount of silicon carbide powder. PTL 1 specifies only the particle size and the added amount of silicon carbide but does not mention the crystal structure or the impurity content. PTL 1 also discloses an embodiment in which high-purity green silicon carbide powder (specifically, Green Densic manufactured by Showa Denko) is used. The main crystal structure of silicon carbide is a regular tetrahedron with a minimum structure, and 4H type and 6H type crystal structures are mainly present due to the stacked structure of the regular tetrahedron. This difference in this crystal structure yields a difference in carrier mobility, which is a characteristic of semiconductors. Compared with the 6H type, the 4H type has a higher carrier mobility, along with a higher dielectric loss tangent tanδ (equal to ε"/ε'), which is related to the electromagnetic wave absorption performance and expressed using the real part of the permittivity ε' and the imaginary part of the permittivity ε" of the electromagnetic wave absorbing sheet. However, the crystal structure of Green Densic is mainly the 6H type, leading to the problem of a low dielectric loss tangent tanδ and poor performance of the electromagnetic wave absorbing sheet.

### CITATION LIST

### Patent Literature

PTL 1: JP 4113812 B2

### SUMMARY

### (Technical Problem)

In view of the aforementioned problem, it is an aim of the present disclosure to provide an electromagnetic wave absorbing sheet that uses silicon carbide powder to impart light weight and high insulation properties and that can obtain an excellent noise attenuation effect in the submillimeter to millimeter wave bands.

### (Solution to Problem)

We carefully examined how to resolve the aforementioned problem and made the following discoveries. By using powder having, as a principal constituent, silicon carbide (SiC), which provides light weight and high insulation, as the dielectric loss material to be supported on the substrate, and by using silicon carbide (SiC) whose X-ray diffraction data falls within specified conditions, the weight can be reduced compared to an electromagnetic wave absorbing sheet that uses carbonyl iron or soft ferrite as a loss filler, and compared to an electromagnetic wave absorbing sheet that uses a carbon-based material as a loss filler, the surface resistivity of the electromagnetic wave absorbing sheet exceeds 10¹⁰ Ω/sq even without mounting an insulation layer such as a PET film on the surface of the sheet. It is also easy to uniformly disperse the silicon carbide powder in the resin substrate, thereby stabilizing the electromagnetic wave absorption properties by suppressing manufacturing variations. Also, compared to conventional electromagnetic wave absorbing sheets that use silicon carbide as a loss filler, the thickness can be reduced, and the electromagnetic wave absorbing properties can be improved.

The primary features of the present disclosure, completed on the basis of these discoveries, are as follows.
[1] An electromagnetic wave absorbing sheet including a substrate made of organic matter and a powder that is supported in the substrate and has silicon carbide, SiC, as a principal constituent, wherein in X-ray diffraction using Cu-Kα as a radiation source on a surface of the electromagnetic wave absorbing sheet, a value I_{4H}/I_{6H} obtained by dividing a peak intensity I_{4H} derived from 4H-SiC appearing at 20 = 34.4° to 35° by a peak intensity I_{6H} derived from 6H-SiC appearing at 20 = 35° to 36° is 0.1 or more.
[2] The electromagnetic wave absorbing sheet according to [1], wherein the electromagnetic wave absorbing sheet has a surface resistivity of 10¹⁰ Ω/sq or more.
[3] The electromagnetic wave absorbing sheet according to [1] or [2], wherein the powder that has silicon carbide, SiC, as a principal constituent has an average particle size of 2 µm or more and 40 µm or less.
[4] The electromagnetic wave absorbing sheet according to any one of [1] to [3], wherein the powder that has silicon carbide, SiC, as a principal constituent has a volume ratio of 20 % or more and 50 % or less relative to the electromagnetic wave absorbing sheet.
[5] The electromagnetic wave absorbing sheet according to any one of [1] to [4], wherein the powder that has silicon carbide, SiC, as a principal constituent has an Al content of 0.1 mass% or more and 0.2 mass% or less, and an Fe content of 0.1 mass% or more and 0.3 mass% or less.

### (Advantageous Effect)

An electromagnetic wave absorbing sheet that uses silicon carbide powder to impart light weight and high insulation properties can obtain an excellent noise attenuation effect in the submillimeter to millimeter wave bands.

### BRIEF DESCRIPTION OF THE DRAWINGS

In the accompanying drawings:

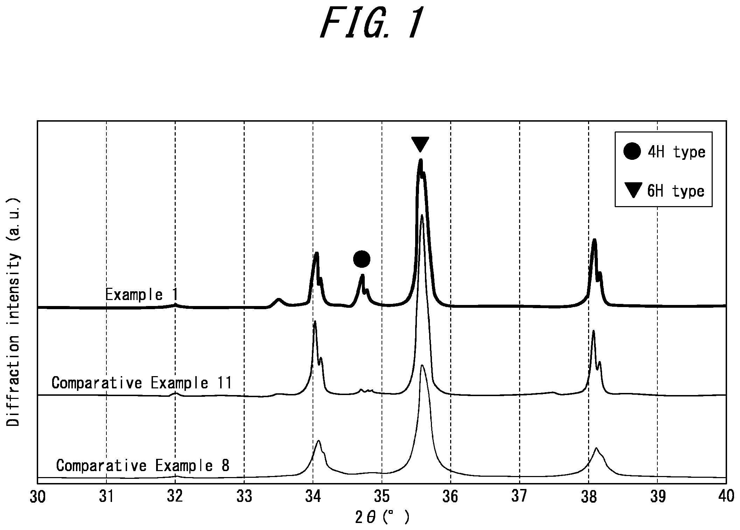

FIG. 1 illustrates an example of an X-ray diffraction measurement chart of an electromagnetic wave absorbing sheet.

### DETAILED DESCRIPTION

Embodiments of the present disclosure are described below.

### (Electromagnetic Wave Absorbing Sheet)

The electromagnetic wave absorbing sheet of the present disclosure includes a substrate made of organic matter and a powder that is supported in the substrate and has silicon carbide (SiC) as a principal constituent. In X-ray diffraction using Cu-Kα as a radiation source on a surface of the electromagnetic wave absorbing sheet, a value I_{4H}/I_{6H} obtained by dividing a peak intensity I_{4H} derived from 4H-SiC appearing at 20 = 34.4° to 35° by a peak intensity I_{6H} derived from 6H-SiC appearing at 20 = 35° to 36° is 1.0 or more.

### [Substrate]

The organic matter forming the substrate is not specified, but since flexibility and cutting processability are generally required for electromagnetic wave absorbing sheets, rubber or elastomer is preferred. Among these materials, silicone resin and acrylic resin have excellent cold/heat resistance and insulation resistance and a history of use in electromagnetic wave absorbing sheets and are therefore particularly preferred as the substrate resin. There are no particular restrictions on the form of the resin raw material, and both millable and liquid forms can be used. Here, an example will be described in which liquid silicone resin is used as the raw material.

Liquid silicone commercially available for general industrial use can be used. Silicones are classified into one-component and two-component types in terms of liquid type, and into condensation reaction and addition reaction types in terms of curing type. Any of these can be used in the present disclosure. The condensation reaction type requires time for curing, whereas the addition reaction type can be expected to cure in a relatively short time by provision of a heating process. Use of the addition reaction type is therefore preferred for productivity. If the viscosity of the liquid silicone is too low, it will not retain its shape well when molded into a sheet, whereas if the viscosity is too high, it will be difficult to uniformly disperse the powder filler. The liquid silicone therefore preferably has a viscosity of 1 Pa·s or more and 10 Pa·s or less.

### [Powder]

The electromagnetic wave absorbing sheet of the present disclosure includes powder as a dielectric loss material supported in the substrate. The powder as a dielectric loss material includes a powder that has silicon carbide (SiC) as a principal constituent (hereinafter also referred to as "silicon carbide powder"). In the present disclosure, silicon carbide powder having a high content ratio I_{4H}/I_{6H} of 4H type to 6H type is used as a loss filler. The crystal structure of silicon carbide is mainly a regular tetrahedron with a minimum structure, and the 4H type and 6H type are mainly present due to the stacked structure of the regular tetrahedron, but the 6H structure is dominant in high-purity green type silicon carbide, whereas the proportion of the 4H type is small. In the present disclosure, low-purity black type silicon carbide is used, in which case the 4H type and 6H type are mixed, and the proportion of the 4H type is high. The silicon carbide powder included in the electromagnetic wave absorbing sheet can be identified by X-ray diffraction using Cu-Kα as a radiation source on the surface of the electromagnetic wave absorbing sheet. The measurement conditions for X-ray diffraction in the present disclosure are as follows.

### <Apparatus>

### Manufacturer: Rigaku

Apparatus name: SmartLab (9kW) fully-automated horizontal multipurpose powerful X-ray diffractometer
Tube bulb: Cu

### <Optical system conditions>

CBO selection slit: BB
Incident parallel slit (Soller/PSC): 5.0 deg
Longitudinal limit slit (IS longitudinal): 10.0 mm
Photosensitive element (PSA): none
Light-receiving parallel slit (Soller): 5.0 deg

### <Measurement conditions>

Scanning axis: 2θ/θ, mode: continuous, range: absolute
Speed counting time: 3.0 degrees/min
Scan: 20 degrees to 80 degrees
Data collection interval: 0.01 degrees
IS: 1/2 degrees
Receiving slit RS1: 8.0 mm
Receiving slit RS2: 13.0 mm
Attenuator: Open

The procedure for analyzing the measured data is as follows. To eliminate the background effect of the data obtained using the integrated powder X-ray diffraction analysis software PDXL produced by Rigaku, the value yobs - bkg obtained by subtracting bkg from the diffraction intensity data yobs was used. The value obtained by subtracting the minimum value from the maximum value of yobs - bkg in the range of 20 = 34.4° to 35° is taken as the peak intensity I_{4H} derived from 4H-SiC. Similarly, the value obtained by subtracting the minimum value from the maximum value of yobs - bkg in the range of 20 = 35° to 36° is taken as the peak intensity I_{6H} derived from 6H-SiC. In the present disclosure, the value I_{4H}/I_{6H} obtained by dividing I_{4H} by I_{6H} is 0.1 or more, preferably 0.2 or more. No upper limit is placed on I_{4H}/I_{6H}, but I_{4H}/I_{6H} is preferably 0.5 or less.

The average particle size of the silicon carbide powder is preferably 2 µm or more, more preferably 3 µm or more, preferably 40 µm or less, and more preferably 20 µm or less. If the average particle size is less than 2 µm, the fluidity and dispersibility of the powder deteriorates, leading to poor manufacturability. On the other hand, if the average particle size is greater than 40 µm, the unevenness of the sheet surface after film formation also increases.

In the present specification, the "average particle size" of silicon carbide powder is determined by the following procedure. First, after ion milling and polishing a cross-section of the electromagnetic wave absorbing sheet, a reflection electron image is taken with a scanning electron microscope. To improve measurement accuracy, the magnification is set to 500x to 4000x according to the powder particle size. In the case of the powder particle size being mainly small, such as 2 µm, 4000x is appropriate, and in the case of the powder particle size being mainly large, such as 40 µm, 500x is appropriate. Next, in the photographed image, the maximum diameter of each silicon carbide powder is taken as the particle size of that powder, and the average value of the particle size of all silicon carbide powders in the photographed field of view is defined as the "average particle size" of the silicon carbide powder contained in the electromagnetic wave absorbing sheet. Powders approaching the edge of the photographed image and powders with a particle size (maximum diameter) of less than 0.1 µm on the photographed image are excluded from measurement.

The added amount of silicon carbide powder varies depending on the average particle size of the powder, the resonance frequency of the designed electromagnetic wave absorbing sheet, and the thickness of the electromagnetic wave absorbing sheet, but if the volume ratio relative to the electromagnetic wave absorbing sheet is 20% or more and 50% or less, the resonance frequency of the electromagnetic wave absorption amount can be adjusted in the submillimeter wave band to the millimeter wave band. If the added amount exceeds 50%, then in a case in which the sheet is manufactured by a wet method such as doctor blade molding, the shrinkage increases in the post-molding heat treatment process of the sheet, and cracks are likely to occur on the sheet surface. In addition, the flexibility of the obtained electromagnetic wave absorbing sheet is also poor. However, in a case in which no problem occurs in the manufacturing process of the electromagnetic wave absorbing sheet and the obtained electromagnetic wave absorbing sheet need not be flexible, the added amount of silicon carbide powder may exceed 50%.

In the present specification, the "added amount" of silicon carbide powder is determined by the following procedure. The reflection electron image used in determining the "average particle size" of the silicon carbide powder described above is used to perform binarization of the color of the image of the substrate made of silicon carbide powder and organic matter, thereby separating the silicon carbide powder from the substrate. After the separation is completed, the area ratio of the silicon carbide powder is determined and defined as the "added amount (volume ratio to the electromagnetic wave absorbing sheet)" of the silicon carbide powder. When performing binarization, appropriate settings can be made so that the boundary between the silicon carbide powder and the substrate becomes clear. Similarly, in a case in which one or more types of additives other than silicon carbide powder are present, separation is performed by multi-value processing, and the area ratios of the silicon carbide powder and the additives are determined, thereby making it possible to determine the "added amount" of each.

Silicon carbide powder that can be used industrially can be used as the silicon carbide powder. Silicon carbide powder for grinding and polishing is an example of silicon carbide powder that can be used industrially and comes in a green type with high purity and a black type with lower purity. The black type is characterized by a higher content of Al and Fe, which are impurity elements, than the green type. Generally, the black type contains 0.1 mass% to 0.2 mass% Al and 0.1 mass% to 0.3 mass% Fe, while the green type contains 0.01 mass% to 0.1 mass% Al and 0.02 mass% to 0.03 mass% Fe. In the present disclosure, a black type silicon carbide powder with a low purity is preferably used as the loss filler. It is also possible to identify the content of Al and Fe, which are impurity elements in silicon carbide. In this case, for example, the Al and Fe contents can be detected by surface analysis of the silicon carbide powder by EPMA (WDS: wavelength dispersive X-ray spectroscopy) on the polished surface (ion milled surface or the like) of the electromagnetic wave absorbing sheet.

Apart from silicon carbide powder, the electromagnetic wave absorbing sheet of the present disclosure may further contain a powder other than silicon carbide powder as a dielectric loss material in the substrate. In addition to the dielectric loss material, the electromagnetic wave absorbing sheet of the present disclosure may contain additives such as flame retardants, material constant adjusters, thermal conductivity enhancers, bulking agents, plasticizers, dispersants, and antioxidants in the substrate as needed, as long as they do not reduce the electromagnetic wave absorption or the surface resistivity, or affect the curing characteristics of the substrate resin. There is no particular restriction on the type of these additives, and it is possible to add only one type, or to add two or more types. As an example of additives, a conductive powder such as aluminum powder, copper powder, or silver powder may be the material constant adjuster. The flame retardant is preferably not an environmentally hazardous substance, and examples include a hydroxyl compound such as aluminum hydroxide or magnesium hydroxide, or a nitrogen compound such as melamine cyanurate. In addition, red phosphorus, which is a flame retardant aid, may also be added as needed. For the purpose of functioning as a material constant adjuster, a bulking agent, or a thermal conductivity enhancer, one or more of the following can be added to the substrate: silicon oxide, aluminum oxide, magnesium oxide, zirconium oxide, boron nitride, aluminum nitride, spherical graphite powder, spinel ferrite, hexagonal ferrite, iron-based magnetic alloys (carbonyl iron, FeSiAl, FeSi, FeSiCr, Fe-based amorphous alloys, Fe-based nanocrystalline alloys), aluminum alloys, and calcium carbonate powder.

When the additive is in powder form, the average particle size of the additive is not particularly limited, but the average particle size is, for example, preferably 2 µm or more, more preferably 3 µm or more, preferably 40 µm or less, and more preferably 20 µm or less. If the average particle size is smaller than 2 µm, the fluidity and dispersibility of the powder deteriorates, leading to poor manufacturability. On the other hand, if the average particle size is greater than 40 µm, the unevenness of the sheet surface after film formation also increases.

In a case in which the additive is in powder form, the added amount of all powder components contained in the substrate varies depending on the average particle size of the powder, the resonance frequency of the designed electromagnetic wave absorbing sheet, and the thickness of the electromagnetic wave absorbing sheet, but if the volume ratio relative to the electromagnetic wave absorbing sheet is 20% or more and 50% or less, the resonance frequency of the electromagnetic wave absorption amount can be adjusted in the submillimeter wave band to the millimeter wave band. If the added amount exceeds 50%, then in a case in which the sheet is manufactured by a wet method such as doctor blade molding, the shrinkage increases in the post-molding heat treatment process of the sheet, and cracks are likely to occur on the sheet surface. In addition, the flexibility of the obtained electromagnetic wave absorbing sheet is also poor. However, in a case in which no problem occurs in the manufacturing process of the electromagnetic wave absorbing sheet and the obtained electromagnetic wave absorbing sheet need not be flexible, the added amount of silicon carbide powder may exceed 50%.

Next, the kneading process for mixing the organic matter that becomes the substrate (raw resin) and the powder components such as silicon carbide powder is described. If the raw resin is liquid silicone rubber, it can be mixed with silicon carbide powder by a planetary mixer. If the raw resin is millable silicone rubber, it can be kneaded using a pressure kneader or open rolls. In this case, it is preferable to cool the material to 100 °C or less so that vulcanization does not proceed due to heat generated by the material during kneading. In addition, in the case of using doctor blade molding, which is a coating method, in the molding method described below, an organic solvent such as toluene or methyl ethyl ketone that has good solubility in the raw resin can be added to the kneaded material as a solvent to adjust the viscosity of the kneaded material and enable doctor blade molding.

The resulting kneaded material can be molded into a sheet by any method such as compression molding, extrusion molding, rolling molding, calendar roll molding, or doctor blade molding. As an example, in the case of compression molding, the kneaded material is placed in a mold that is carved so that the electromagnetic wave absorbing sheet after molding has a predetermined thickness, and compression molding is performed at a temperature of 120 °C to 200 °C, at which the vulcanization of the silicone progresses, for 5 min to 30 min.

The surface resistivity of the electromagnetic wave absorbing sheet is preferably 10¹⁰ Ω/sq or more and is more preferably 10¹¹ Ω/sq or more. If the surface resistivity of the electromagnetic wave absorbing sheet is 10¹⁰ Ω/sq or more, sufficiently high insulation can be obtained. For example, even if the electromagnetic wave absorbing sheet falls off from the mounting portion, the risk of the electromagnetic wave absorbing sheet coming into contact with and shorting a circuit can be reduced.

The thickness of the electromagnetic wave absorbing sheet is preferably 0.15 mm or more and 1 mm or less. If the thickness of the sheet is less than 0.15 mm, the sheet will not be strong enough to be handled. If the thickness exceeds 1 mm, the sheet will not be compatible with a reduction in thickness and size of electronic devices. In the case of an electromagnetic wave absorbing sheet, depending on the relative permittivity of the base material, if the thickness is within the range of 0.15 mm or more and 1 mm or less, the resonance frequency of the electromagnetic wave absorbing sheet can be adjusted in the submillimeter wave band to the millimeter wave band.

Since the electromagnetic wave absorbing sheet is used by being attached to some object, an adhesive layer or the like may be mounted on the back of the sheet. If the object to which the electromagnetic wave absorbing sheet is attached is not a conductive object, a conductive layer of metal or the like can be mounted on the back of the electromagnetic wave absorbing sheet. There are no particular restrictions on the material of the conductive layer, but metal materials are generally used. Examples of the metal include brass, copper, iron, nickel, stainless steel, and aluminum. The conductive layer is not limited to a single metal and may, for example, be formed by vapor deposition of aluminum on a film. The thickness of the conductive layer may be set in consideration of the ability to reflect the electromagnetic waves incident on the electromagnetic wave absorbing sheet and of excellent flexibility, and the thickness is preferably 10 nm or more and 300 µm or less, particularly preferably 50 nm or more and 100 µm or less. If the thickness of the conductive layer is less than 10 nm, the electromagnetic waves incident on the electromagnetic wave absorbing sheet will pass through the conductive layer, and the amount of reflection at the conductive layer will decrease. On the other hand, if the thickness of the conductive layer is greater than 300 µm, the total thickness of the electromagnetic wave absorbing sheet will be large, and additionally the flexibility of the sheet will be lost.

The sheet of the present disclosure has been described assuming the case of an electromagnetic wave absorbing sheet used in the far field, but the sheet can also be used as a noise suppression sheet for the near field. The sheet of the present disclosure uses silicon carbide powder as a loss material and acts as a near-field noise suppression sheet that suppresses electric field noise by electrical and dielectric losses. A sheet having the substrate configuration of the present disclosure has a dielectric loss tangent tanδ (equal to ε"/ε') exceeding 0.2, the dielectric loss tangent tanδ being an index expressing the degree of energy loss when the real part of the permittivity is ε' and the imaginary part of the permittivity is ε". A practical noise suppression sheet is thus achieved. In addition, since silicon carbide powder has a high thermal conductivity of 100 W/mK to 350 W/mK, a sheet having the substrate configuration of the present disclosure can achieve a thermal conductivity of more than 0.5 W/mK and can be used as a sheet that combines noise suppression and thermal conductivity.

### EXAMPLES

The present disclosure is described below with reference to Examples of an electromagnetic wave absorbing sheet that maximizes the reflection attenuation amount at 76.5 GHz, but the present disclosure is not limited to these Examples.

### <Production of Electromagnetic Wave Absorbing Sheet>

The doctor blade molding method was used to produce an electromagnetic wave absorbing sheet. Silicone resin, silicon carbide powder, and toluene as a solvent were mixed with a planetary mixer and used as the coating liquid. This coating liquid was cast onto a PET film by doctor blade molding, and heat treatment was then performed to remove the toluene and cure the silicone resin, thereby producing an electromagnetic wave absorbing sheet of a predetermined thickness. Silicon carbide powders having different I_{4H}/I_{6H} were appropriately used to produce Examples 1 to 14 and Comparative Examples 1 to 13. The average particle size, added amount, Al content, and Fe content of the silicon carbide powders are listed in Table 1. The thickness of the sheet was determined to optimize the electromagnetic wave absorption amount within a certain level of the average particle size and added amount.

### <Characteristics evaluation>

### {I_{4H}/I_{6H} calculated from X-ray diffraction measurement}

The measurement conditions and analysis procedures were as described in the embodiment, and the results are listed in Table 1. FIG. 1 illustrates an example of an X-ray diffraction measurement chart of the electromagnetic wave absorbing sheet in Example 1, Comparative Example 8, and Comparative Example 11.

### {Real part of permittivity ε', imaginary part of permittivity ε", and dielectric loss tangent tanδ}

[Vector network analyzer]
Manufacturer: KEYSIGHT TECHNOLOGY
Name of apparatus: Vector Network Analyzer M9374A (60 GHz to 90 GHz) [Apparatus jig]
Manufacturer: KEYCOM
Name of apparatus: S-parameter method, free-space type, relative permittivity measurement system DPS24

### [Software]

Manufacturer: KEYSIGHT TECHNOLOGY
Name of software: VNA Soft Front Panel

### [Software]

Manufacturer: KEYCOM
Name of software: S-parameter method, permittivity permeability measurement program

### [Measurement conditions]

Frequency range: 60 GHz to 90 GHz
Number of data points: 1601
Port Power (Port 1): 2 dBm
Bandwidth: 1 kHz

The time domain method is used to eliminate the effects of reflected and scattered waves from areas other than the vicinity of the sample.
Time gate span: 0.5 ns

### [Measurement method]

With the produced sheet fixed to the apparatus, the real part of the permittivity ε' and the imaginary part of the permittivity ε" were measured, and the dielectric loss tangent tanδ = ε"/ε' was calculated by dividing ε" by ε'. The results at a frequency of 76.5 GHz are listed in Table 1.

### {Electromagnetic wave absorption amount}

### [Apparatus]

Manufacturer: KEYSIGHT TECHNOLOGY
Name of apparatus: Vector Network Analyzer M9374A (60 GHz to 90 GHz) and
Manufacturer: KEYCOM
Name of apparatus: Lens antenna method, oblique incidence type, reflection attenuation amount measurement apparatus LAF-26.5A

### [Software]

### Manufacturer: KEYSIGHT TECHNOLOGY

Name of software: VNA Soft Front Panel
   and
Manufacturer: KEYCOM
Name of software: Free space type electromagnetic wave absorption amount measurement program

### [Measurement conditions]

Frequency range: 60 GHz to 90 GHz
Number of data points: 1601
Port Power (Port 1): 2 dBm
Bandwidth: 1 kHz

The time domain method is used to eliminate the effects of reflected and scattered waves from areas other than the vicinity of the sample.
Time gate span: 0.5 ns

### [Measurement method]

The electromagnetic wave absorption amount was measured with the produced sheet attached to the metal base of the reflection attenuation amount measurement apparatus using double-sided tape as an adhesive layer on the back side of the sheet. The results at a frequency of 76.5 GHz are listed in Table 1. Note that in judging the results in Table 1, an electromagnetic wave absorption amount of 10 dB or more was judged as OK, and less than 10 dB as NG (not acceptable).

### {Surface resistivity}

### [Apparatus]

Manufacturer: SIMCO JAPAN
Name of apparatus: Surface resistivity meter ST-4

### [Measurement method]

The surface resistivity of the produced sheet was measured with the surface resistivity meter ST-4 placed on the surface of the sheet, and the measured surface resistivity was expressed as 10 × Ω/sq. The results are listed in Table 1. In judging the results in Table 1, a value of 10¹⁰ Ω/sq or more was judged as OK, and a value of less than 10¹⁰ Ω/sq as NG.

### {Sheet appearance}

The surface condition of the sheet was judged visually and by touch, and the results are listed in Table 1. In judging the results in Table 1, a smooth surface without cracks or unevenness was judged as OK, and a surface with cracks or unevenness was judged as NG.

### {Overall judgment}

A sheet that was judged to be OK in all three categories of electromagnetic wave absorption, surface resistivity, and sheet appearance was judged as OK overall, and all other sheets were judged as NG overall, as listed in Table 1.

### <Results>

The results for Examples 1 to 14 and Comparative Examples 1 to 13 are listed in Table 1.

### - Examples 1 to 12

These Examples are electromagnetic wave absorbing sheets with an average particle size and added amount of silicon carbide powder within the ranges of the present embodiment. I_{4H}/I_{6H} is greater than 0.2 for all of the sheets, and the electromagnetic wave absorption amount is greater than 10 dB. In addition, the surface resistivity is greater than 10¹⁰ Ω/sq, and the sheet surface is smooth.

### - Examples 13, 14

These Examples are electromagnetic wave absorbing sheets with an average particle size and added amount of silicon carbide powder within the ranges of the present embodiment. I_{4H}/I_{6H} is 0.1 or more and less than 0.2 for all of the sheets, and the electromagnetic wave absorption amount is greater than 10 dB. In addition, the surface resistivity is greater than 10¹⁰ Ω/sq, and the sheet surface is smooth.

### - Comparative Examples 1, 3, 5, 6

These Comparative Examples are electromagnetic wave absorbing sheets with an added amount of silicon carbide powder below the range of the present embodiment. I_{4H}/I_{6H} is greater than 0.2 for all of the sheets, but the dielectric loss tangent is below 0.2, and the electromagnetic wave absorption amount is less than 10 dB.

### - Comparative Examples 2, 4

These Comparative Examples are electromagnetic wave absorbing sheets with an added amount of silicon carbide powder exceeding the range of the present embodiment. Shrinkage increased during the heat treatment of the sheet after molding, causing cracks on the sheet surface.

### - Comparative Example 7

This Comparative Example is an electromagnetic wave absorbing sheet with an average particle size exceeding the range of the present embodiment. Unevenness was observed on the surface of the sheet after molding.

### - Comparative Examples 8 to 13

These Comparative Examples are electromagnetic wave absorbing sheets with lower I_{4H}/I_{6H} than the range of the present disclosure. I_{4H}/I_{6H} is less than 0.1 for all of the sheets, and the electromagnetic wave absorption amount is less than 10 dB. Also, in Comparative Examples 10 and 13, the added amount of silicon carbide powder was greater than the range of the present embodiment, thereby increasing shrinkage during the heat treatment of the sheet after molding and causing cracks on the sheet surface.

**[Table 1]**

| No. | Powder type | Average particle size (µm) | Al content (mass%) | Fe content (mass%) | Added amount (Vol%) | Thickness (mm) | XRD I_{4H}/I_{6H} | Permittivity at 76.5 GHz | | | Electromagnetic wave absorption amount (dB) | | Surface resistivity | | Sheet appearance | | Overall judgment |
|---|---|---|---|---|---|---|---|---|---|---|---|---|---|---|---|---|---|
| | | | | | | | | real part ε' | imaginary part ε" | tanδ | at 76.5GHz | judgment | 10 × Ω/sq | judgment | surface state | judgment | |
| Comparative Example 1 | black | 2.3 | 0.177 | 0.286 | 15.1 | 0.45 | 0.23 | 4.67 | 0.90 | 0.19 | 5.8 | NG | > 13.5 | OK | smooth | OK | NG |
| Example 1 | | | | | 20.7 | 0.35 | 0.24 | 5.32 | 1.46 | 0.27 | 10.1 | OK | > 13.5 | OK | smooth | OK | OK |
| Example 2 | | | | | 35.5 | 0.25 | 0.29 | 8.09 | 3.52 | 0.44 | 36.1 | OK | 12.7 | OK | smooth | OK | OK |
| Example 3 | | | | | 49.7 | 0.20 | 0.27 | 12.17 | 6.56 | 0.54 | 14.0 | OK | 11.1 | OK | smooth | OK | OK |
| Comparative Example 2 | | | | | 55.6 | 0.15 | 0.31 | 14.14 | 8.04 | 0.57 | 11.4 | OK | 10.5 | OK | cracked | NG | NG |
| Comparative Example 3 | | 8.5 | 0.135 | 0.169 | 15.2 | 0.45 | 0.34 | 4.70 | 0.85 | 0.18 | 5.4 | NG | > 13.5 | OK | smooth | OK | NG |
| Example 4 | | | | | 20.2 | 0.35 | 0.23 | 5.40 | 1.48 | 0.27 | 10.2 | OK | > 13.5 | OK | smooth | OK | OK |
| Example 5 | | | | | 35.3 | 0.25 | 0.30 | 7.99 | 3.43 | 0.43 | 32.8 | OK | 12.7 | OK | smooth | OK | OK |
| Example 6 | | | | | 49.5 | 0.20 | 0.26 | 12.20 | 6.60 | 0.54 | 13.9 | OK | 11.4 | OK | smooth | OK | OK |
| Comparative Example 4 | | | | | 54.8 | 0.15 | 0.23 | 14.20 | 8.25 | 0.58 | 11.3 | OK | 10.6 | OK | cracked | NG | NG |
| Comparative Example 5 | | 22.6 | 0.156 | 0.250 | 14.8 | 0.45 | 0.28 | 4.61 | 0.87 | 0.19 | 5.7 | NG | > 13.5 | OK | smooth | OK | NG |
| Example 7 | | | | | 20.6 | 0.35 | 0.35 | 5.60 | 1.49 | 0.27 | 10.0 | OK | > 13.5 | OK | smooth | OK | OK |
| Example 8 | | | | | 34.7 | 0.25 | 0.26 | 8.15 | 3.50 | 0.43 | 31.1 | OK | 12.4 | OK | smooth | OK | OK |
| Example 9 | | | | | 49.1 | 0.20 | 0.25 | 12.06 | 6.45 | 0.53 | 14.5 | OK | 11.2 | OK | smooth | OK | OK |
| Comparative Example 6 | | 38.2 | 0.121 | 0.192 | 15.0 | 0.45 | 0.25 | 4.80 | 0.89 | 0.19 | 5.4 | NG | > 13.5 | OK | smooth | OK | NG |
| Example 10 | | | | | 20.4 | 0.35 | 0.23 | 5.18 | 1.50 | 0.29 | 10.5 | OK | > 13.5 | OK | smooth | OK | OK |
| Example 11 | | | | | 35.1 | 0.25 | 0.29 | 8.02 | 3.45 | 0.43 | 33.7 | OK | 12.6 | OK | smooth | OK | OK |
| Example 12 | | | | | 49.8 | 0.20 | 0.30 | 12.25 | 6.68 | 0.55 | 13.6 | OK | 11.3 | OK | smooth | OK | OK |
| Comparative Example 7 | | 51.2 | 0.108 | 0.127 | 35.0 | 0.25 | 0.23 | 7.93 | 3.36 | 0.42 | 29.7 | OK | 12.7 | OK | uneven | NG | NG |
| Example 13 | | 8.3 | 0.114 | 0.142 | 35.2 | 0.25 | 0.11 | 6.85 | 1.84 | 0.27 | 10.5 | OK | 13.4 | OK | smooth | OK | OK |
| Example 14 | | | | | 35.1 | 0.25 | 0.16 | 7.18 | 2.33 | 0.32 | 13.5 | OK | 12.9 | OK | smooth | OK | OK |
| Comparative Example 8 | green | 2.2 | 0.024 | 0.021 | 14.8 | 0.45 | 0.01 | 4.58 | 0.45 | 0.10 | 3.0 | NG | > 13.5 | OK | smooth | OK | NG |
| Comparative Example 9 | | | | | 35.4 | 0.45 | 0.01 | 4.63 | 0.46 | 0.10 | 3.0 | NG | > 13.5 | OK | smooth | OK | NG |
| Comparative Example 10 | | | | | 55.2 | 0.45 | 0.01 | 4.85 | 0.47 | 0.10 | 2.8 | NG | > 13.5 | OK | cracked | NG | NG |
| Comparative Example 11 | | 8.3 | 0.037 | 0.025 | 15.1 | 0.45 | 0.03 | 4.05 | 0.41 | 0.10 | 3.1 | NG | > 13.5 | OK | smooth | OK | NG |
| Comparative Example 12 | | | | | 35.4 | 0.25 | 0.03 | 6.90 | 1.32 | 0.19 | 7.2 | NG | > 13.5 | OK | smooth | OK | NG |
| Comparative Example 13 | | | | | 55.0 | 0.15 | 0.03 | 12.35 | 3.52 | 0.29 | 6.0 | NG | 13.4 | OK | cracked | NG | NG |

### INDUSTRIAL APPLICABILITY

The electromagnetic wave absorbing sheet of the present disclosure is particularly effective as an electromagnetic noise countermeasure component that is mounted on an electronic device and absorbs electromagnetic waves generated within the electronic device. By virtue of being lighter, thinner, and more insulating than conventional products, this electromagnetic wave absorbing sheet is industrially useful.

## Claims

1. An electromagnetic wave absorbing sheet comprising a substrate made of organic matter and a powder that is supported in the substrate and has silicon carbide, SiC, as a principal constituent, wherein in X-ray diffraction using Cu-Kα as a radiation source on a surface of the electromagnetic wave absorbing sheet, a value I_{4H}/I_{6H} obtained by dividing a peak intensity I_{4H} derived from 4H-SiC appearing at 20 = 34.4° to 35° by a peak intensity I_{6H} derived from 6H-SiC appearing at 20 = 35° to 36° is 0.1 or more.

2. The electromagnetic wave absorbing sheet according to claim 1, wherein the electromagnetic wave absorbing sheet has a surface resistivity of 10¹⁰ Ω/sq or more.

3. The electromagnetic wave absorbing sheet according to claim 1 or 2, wherein the powder that has silicon carbide, SiC, as a principal constituent has an average particle size of 2 µm or more and 40 µm or less.

4. The electromagnetic wave absorbing sheet according to claim 1 or 2, wherein the powder that has silicon carbide, SiC, as a principal constituent has a volume ratio of 20 % or more and 50 % or less relative to the electromagnetic wave absorbing sheet.

5. The electromagnetic wave absorbing sheet according to claim 1 or 2, wherein the powder that has silicon carbide, SiC, as a principal constituent has an Al content of 0.1 mass% or more and 0.2 mass% or less, and an Fe content of 0.1 mass% or more and 0.3 mass% or less.
